Europäisches Patentamt

European Patent Office

Office européen des brevets

(19)

(11) **EP 0 832 545 B1**

(12) **EUROPÄISCHE PATENTSCHRIFT**

(45) Veröffentlichungstag und Bekanntmachung des Hinweises auf die Patenterteilung:
**20.01.1999 Patentblatt 1999/03**

(21) Anmeldenummer: **96943855.5**

(22) Anmeldetag: **06.09.1996**

(51) Int Cl.⁶: **H05K 3/26**

(86) Internationale Anmeldenummer:
**PCT/DE96/01716**

(87) Internationale Veröffentlichungsnummer:
**WO 97/11209 (27.03.1997 Gazette 1997/14)**

(54) **VERFAHREN UND VORRICHTUNG ZUM BEHANDELN VON SICH IN WERKSTÜCKE ERSTRECKENDEN LÖCHERN ODER VERTIEFUNGEN MIT FLÜSSIGEN BEHANDLUNGSMITTELN**

PROCESS AND DEVICE FOR TREATING HOLES OR RECESSES IN WORKPIECES WITH LIQUID TREATMENT AGENTS

PROCEDE ET DISPOSITIF POUR TRAITER DES TROUS OU DES EVIDEMENTS DANS DES PIECES AVEC DES AGENTS LIQUIDES DE TRAITEMENT

(84) Benannte Vertragsstaaten:
**AT DE FR GB IT NL SE**

(30) Priorität: **06.09.1995 DE 19534521**

(43) Veröffentlichungstag der Anmeldung:
**01.04.1998 Patentblatt 1998/14**

(73) Patentinhaber: **ATOTECH Deutschland GmbH
10553 Berlin (DE)**

(72) Erfinder:
• **DURST, Franz
D-91094 Langensendelbach (DE)**
• **BRENN, Günter
D-91052 Erlangen (DE)**
• **SCHÄFER, Michael
D-90425 Nürnberg (DE)**
• **MEYER, Heinrich
D-14109 Berlin (DE)**
• **STREUP, Heribert
D-12277 Berlin (DE)**

(74) Vertreter: **Effert, Bressel und Kollegen
Radickestrasse 48
12489 Berlin (DE)**

(56) Entgegenhaltungen:
DE-A- 3 708 529      DE-A- 3 905 100
DE-C- 3 305 564      US-A- 4 789 405

**Beschreibung**

Die Erfindung betrifft ein Verfahren und eine Vorrichtung zum Behandeln von sich in Werkstücke erstreckenden sehr kleinen Löchern oder Vertiefungen mit flüssigen Behandlungsmitteln.

Sollen Werkstückoberflächen mit Flüssigkeiten behandelt werden, so werden die Oberflächen mit den Behandlungsmitteln in der Regel durch Eintauchen in Kontakt gebracht. Typische Anwendungsbeispiele stellen das Reinigen von Substraten, beispielsweise von Kleidungsstücken, die galvanotechnische Behandlung von Metall- und Kunststoffteilen sowie die galvanotechnischen Verfahrensschritte bei der Herstellung von Leiterplatten dar.

In vielen Bereichen der Technik werden dünne Metallschichten auf die Oberflächen von Materialien aufgetragen, um den Oberflächen bestimmte Eigenschaften zu verleihen, die für die Nutzung der Materialien für technische Anwendungsfälle benötigt werden. Obwohl heute bereits eine Vielzahl unterschiedlicher Beschichtungstechniken zur Verfügung steht, stellen galvanische Metallabscheidungsverfahren trotz der häufig auftretenden verfahrensspezifischen Probleme nach wie vor wichtige Behandlungsmethoden dar.

Beispielsweise können Probleme entstehen, wenn Werkstücke mit sehr kleinen Löchern oder anderen sich von der Oberfläche her in die Werkstücke erstreckenden Vertiefungen mit geringen Abmessungen mit flüssigen Mitteln behandelt werden sollen. In diesem Fall werden diese Löcher und Vertiefungen von der Flüssigkeit nicht ausreichend oder überhaupt nicht mehr durchspült, so daß der gewünschte Behandlungserfolg nicht erzielt werden kann.

In der Leiterplattentechnik beispielsweise müssen die Wandungen der Löcher, die sich durch das Leiterplattenlaminat hindurch erstrecken oder die als Sacklöcher angebracht sind, mit einer Metallschicht versehen werden. Hierzu sind diese Löcher oder Vertiefungen nach ihrer Herstellung, beispielsweise durch Bohren, im allgemeinen zunächst von Verunreinigungen zu befreien, beispielsweise von den beim Bohren entstehenden Harzverschmierungen auf der Bohrlochwand, indem die Leiterplatte mit Ätzmitteln in Kontakt gebracht wird. Weiterhin werden zur Reinigung der Löcher auch chemische Lösungen mit oberflächenaktiven Substanzen (Netzmittel) eingesetzt. Nach der Reinigung werden die elektrisch nichtleitenden Bohrlochwände mit Edelmetall enthaltenden Lösungen aktiviert und nachfolgend mit stromlos arbeitenden Metallisierungslösungen in der Regel verkupfert oder vernickelt. Anschließend wird eine Metallschicht mit einer Dicke von etwa 20 µm mittels elektrolytischer Abscheidung auf den Wandflächen der Löcher abgeschieden.

Durch die Miniaturisierung der Schaltungsstrukturen auf Leiterplatten werden immer kleinere Löcher, beispielsweise mit einem Durchmesser von 0,2 mm, in den Leiterplatten gebildet, die nach wie vor sicher metallisiert werden müssen. Daher sind verschiedene Verfahrensweisen vorgeschlagen worden, um Luft aus diesen Löchern auszutreiben und einen ausreichenden Flüssigkeitsaustausch zwischen dem Lochinneren und dem flüssigen Behandlungsmittel außerhalb der Löcher zu gewährleisten. Es müssen spezielle Methoden zur Durchströmung dieser sehr kleinen Löcher eingesetzt werden.

In der deutschen Offenlegungsschrift DE 35 28 575 A1 sind hierzu ein Verfahren zur Reinigung, Aktivierung und/ oder Metallisierung von Bohrlöchern in horizontal geführten Leiterplatten, bei dem die Leiterplatten mit konstanter Geschwindigkeit über eine Schwallstrecke hinweg laufen, die von einer unterhalb der Transportbahn und senkrecht zur Transportrichtung angeordneten Düse gebildet wird, aus dem das flüssige Behandlungsmittel in Form einer stehenden Welle an die Unterseite der Leiterplatte gefördert wird, sowie eine Einrichtung zur Durchführung dieses Verfahrens offenbart.

Zu dieser Verfahrensweise sind weitere Druckschriften veröffentlicht worden, in denen spezielle Anwendungen der Durchströmung der Bohrungen von Leiterplatten beschrieben werden (beispielsweise in DE 36 38 630 A1, DE 36 24 481 A1).

Eine andere Lösung ist der deutschen Patentschrift DE 39 05 100 C2 zu entnehmen, in der ein Verfahren zur chemischen oder elektrolytischen Oberflächenbehandlung von mit kleinen Öffnungen versehenen plattenförmigen Werkstücken in wäßrigen Lösungen vorgeschlagen wird, wobei das Werkstück zwei selbständige, voneinander unabhängige Schwingungsbewegungen ausführt. Die erste der beiden Schwingungsbewegungen verläuft rechtwinklig zur Fläche des Werkstücks und die zweite in etwa derselben Richtung wie die erste und gleichzeitig mit dieser, wobei die Frequenz der ersten Bewegung wesentlich niedriger ist als die der zweiten, die eine in rascher Folge heftig pulsierende Vibrationsschwingung darstellt. Die Amplitude der ersten Schwingungsbewegung ist wesentlich größer als die der zweiten.

Numerische Simulationen zur Bestimmung der Strömungsverhältnisse in Bohrlöchern von Leiterplatten haben darüber hinaus gezeigt, daß derartige senkrecht zur Oberfläche der Leiterplatten gerichteten Vibrationsschwingungen den Flüssigkeitsaustausch wirksamer unterstützen als Vibrationsschwingungen, die ausschließlich Schwingungskomponenten parallel zur Leiterplattenoberfläche aufweisen.

Jedoch sind die genannten Problemlösungen für die sichere Behandlung sehr kleiner Löcher und insbesondere von Sacklöchern nicht geeignet, da sich in diesen Fällen nur im Eingangsbereich der Löcher Strömungen ausbilden. Sacklöcher und andere Vertiefungen erstrecken sich nur bis zu einer bestimmten Tiefe in ein Werkstück oder einen Festkörper. Abgesehen von Problemen, die auch bei sehr kleinen Durchgangslöchern auftreten, besteht hier zusätzlich das Problem, daß die einströmende Flüssigkeit auch wieder herausströmen muß, um einen ausreichenden Flüssigkeitsaustausch zu erreichen. Sonst wäre allenfalls ein sehr langsamer Stoffaustausch mittels Diffusion möglich.

Aufgrund der an der Lochwand anhaftenden Grenzschicht bzw. einer endlichen Viskosität verwendbarer Behandlungsflüssigkeiten können in diesen Löchern durch Schwingungsbewegungen in einer Tiefe, die beispielsweise bei Verwendung wäßriger Behandlungsflüssigkeiten etwa dem Durchmesser des Loches entspricht, keine Strömungen mehr erzeugt werden.

Zur Behandlung von Leiterplatten mit Sacklöchern ist es beispielsweise üblich, die Leiterplatten in einer Vorrichtung zu behandeln, bei der die Leiterplatten in horizontaler Lage und horizontaler Richtung durch eine Behandlungskammer hindurchgeführt werden, wobei sich die Leiterplatten während des Durchlaufes innerhalb der Behandlungsflüssigkeit befinden. Dadurch kann zumindest erreicht werden, daß aus den an der Oberseite der Leiterplatten befindlichen Löchern Gasblasen einigermaßen problemlos entfernt werden können. Ein sicherer Stoffaustausch innerhalb der für die Behandlung zur Verfügung stehenden Zeit und insbesondere auch die Entfernung von Gasblasen aus Löchern an der Unterseite der Leiterplatten ist mit dieser Methode jedoch nicht möglich. Zudem können Gasblasen aus Löchern, bei denen das Verhältnis von Loch länge zu Lochdurchmesser einen Wert von etwa 1 übersteigt, auch mit diesem Verfahren nicht mehr sicher entfernt werden.

Der Erfindung liegt von daher das Problem zugrunde, die Nachteile des Standes der Technik zu vermeiden und insbesondere ein sicheres Verfahren sowie eine hierzu geeignete Vorrichtung zum Spülen von in Werkstücken vorgesehenen Löchern und anderen nach außen offenen kleinsten Hohlräumen sowie Vertiefungen mit einer Öffnungsweite unter 0,5 mm mit einem flüssigen Behandlungsmittel zu finden. Es sollen insbesondere ein Verfahren und eine Vorrichtung zur Behandlung von mit Sacklöchern versehenen Leiterplatten bereitgestellt werden.

Gelöst wird das Problem durch die Gegenstände der Ansprüche 1, 7 und 8. Vorteilhafte Ausführungsformen der Erfindung sind in den Unteransprüchen angegeben.

Die Lösung des Problems besteht darin, einen Flüssigkeitsstrahl des Behandlungsmittels auf die Oberfläche des zu behandelnden Substrats zu richten, der einen Strahldurchmesser aufweist, der kleiner ist als die Öffnungsweite der Löcher oder Vertiefungen, bei Bohrungen also des Durchmessers der zu behandelnden Löcher in der Oberfläche des Substrats. Unter Substrat wird ein beliebiger Festkörper oder ein zu behandelndes Werkstück verstanden. Dadurch wird eine in das Innere der Löcher und Vertiefungen gerichtete Strömung des Behandlungsmittels ermöglicht, so daß auch eine wirksame Spülung von Sacklöchern erreicht wird, selbst wenn diese Löcher einen sehr kleinen Durchmesser aufweisen, beispielsweise von 75 μm. Der ins Innere der Vertiefung gerichtete Strahl wird an dessen Boden umgelenkt, so daß sich innerhalb des Loches zusätzlich auswärts gerichtete Strömungen des Behandlungsmittels ausbilden.

Die erfindungsgemäße Wirkung entfaltet sich vor allem dann, wenn der Behandlungsmittelstrahl einen Durchmesser aufweist, der maximal die Hälfte des Lochdurchmessers beträgt. Liegt ein Strahl mit einem Strahldurchmesser vor, der größer ist als der Lochdurchmesser, kann die erfindungsgemäße Strömungswirkung im Loch nicht mehr erzielt werden.

Anhand der nachfolgend beschriebenen Zeichnungen und Abbildungen wird das erfindungsgemäße Verfahren erläutert und die Vorrichtung schematisch dargestellt bzw. Einzelheiten der Vorrichtung mittels photographischer Abbildungen wiedergegeben. Es zeigen:

Fig. 1:     Querschnitt durch ein Sackloch in einer Leiterplatte, schematische Darstellung;

Fig. 2:     Strömungsverhältnisse in einem Sackloch, Computersimulation;

Fig. 3:     Stabilitätskurve eines Behandlungsmittelstrahls in Luft, schematische Darstellung;

Abb. 4:     Ansicht der Düsenaustrittsöffnungen in einer Mehrlochdüse, rasterelektronenmikroskopische Aufnahme;

Fig. 5:     Erfindungsgemäße Vorrichtung, schematische Darstellung;

Fig. 6:     Düsenkammer mit mehreren Düsenöffnungen, schematische Darstellung;

Abb. 7:     Düsenöffnung, rasterelektronenmikroskopische Aufnahme;

Fig. 8:     Behandlungsanlage zum horizontalen Behandeln von Leiterplatten, schematische Seitenansicht.

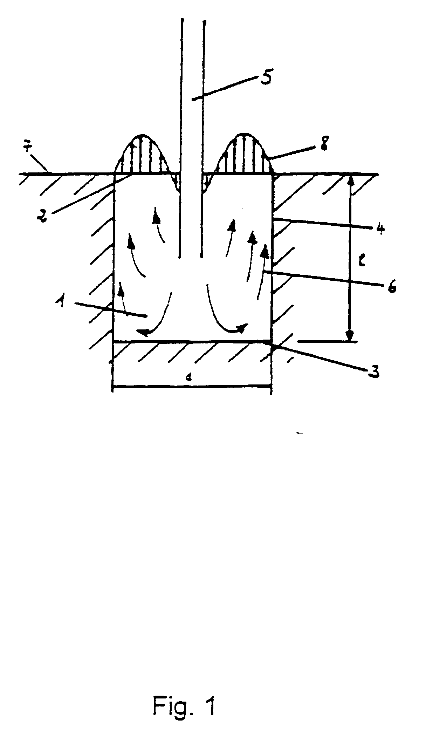

In Fig. 1 sind die sich einstellenden Strömungsverhältnisse in einem Sackloch in einer Leiterplatte schematisch dargestellt. Wird der Behandlungsmittelstrahl 5 mittig und entlang der Lochachse in das vorzugsweise zylindrische Loch 1 (Lochlänge 1, Lochdurchmesser d) durch den Locheingang 2 einer Leiterplatte 7 gelenkt, so entsteht die schematisch dargestellte Strömungsverteilung innerhalb des Loches. Die einzelnen Pfeile 6 charakterisieren lokale Strömungskomponenten. Der abwärts gerichtete Strahl 5 wird am Lochboden 3 nach oben umgelenkt. Dadurch entsteht eine starke ringförmige auswärts gerichtete Strömung entlang der zu behandelnden Wandung 4 des Loches, so daß Gasblasen, die durch die Oberflächenspannung dort festgehalten werden, von dieser abgerissen werden. Ferner wird dadurch auch der für die Behandlung der Wandung und des Lochbodens erforderliche Stofftransport ermöglicht, durch den verbrauchte Stoffe weg- und für die Behandlung benötigte Stoffe hintransportiert werden. Diese Strömungskomponenten summieren sich in der Nähe der Lochmantelflächen und bilden ein im wesentlichen ringförmiges, aus dem Loch heraus gerichtetes Strömungsprofil 8 aus.

Handelt es sich bei den Vertiefungen um längliche Löcher, so wird der Behandlungsmittelstrahl vorzugsweise im wesentlichen parallel zur Längsachse der Löcher geführt.

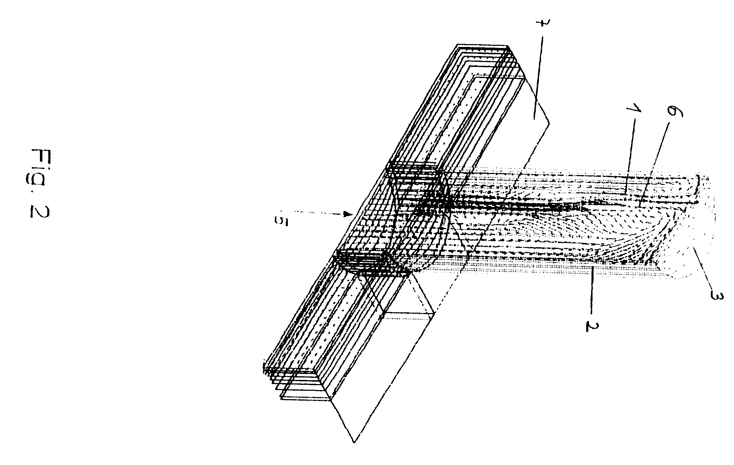

In einem numerischen Simulationsverfahren nach dem Prinzip der Finite-Volumen-Methode (beispielsweise beschrieben in: E. Noll, "Numerische Strömungstechnik", Springer-Verlag Berlin, New York, 1993), können die Strömungsverhältnisse in einem Sackloch graphisch dargestellt werden. In Fig. 2 ist hier ein Schnitt durch ein Sackloch 1 in einer Leiterplatte 7 sowie die Richtung der einzelnen Strömungskomponenten in dem Loch, durch Pfeile 6 markiert, wiedergegeben. Der in das Loch gerichtete Flüssigkeitsstrahl 5 ist in diesem Fall nicht genau mittig ausgerichtet und wird durch die aufwärts gerichteten, durch Umlenkung am Lochboden 3 gebildeten Strömungskomponenten 6 leicht abgelenkt. Trotzdem bildet sich ein an den Wandungen 4 des Loches anliegendes zum Locheingang auswärts gerichtetes Strömungsprofil aus, so daß sich die erfindungsgemäßen Wirkungen ergeben.

Der vorteilhafte erfindungsgemäße Effekt wird nur dann erreicht, wenn der Strahldurchmesser kleiner ist als die Öffnungsweite der zu behandelnden Vertiefungen. Es werden besonders gute Wirkungen erreicht, wenn der Strahldurchmesser kleiner ist als die Hälfte der Öffnungsweite der Vertiefungen oder des Durchmessers der Löcher.

Andererseits nimmt die Strömungsgeschwindigkeit im Inneren des Loches bei sehr kleinen Strahldurchmessern wieder ab, da der zur Verfügung stehende Impuls des in das Loch hinein gerichteten Strahles dann geringer ist. Diese Wirkung ist in der Tabelle 1 wiedergegeben. Flüssigkeitsstrahlen mit unterschiedlichen Strahldurchmessern wurden mit verschiedenen Strahlgeschwindigkeiten in ein Loch mit einem Durchmesser von 0,3 mm und einer Tiefe von 0,8 mm gerichtet. Die erfindungsgemäße Wirkung der Durchspülung wird durch die sich noch unmittelbar über dem Lochboden einstellende Flüssigkeitsgeschwindigkeit (Bodengeschwindigkeit) wiedergegeben.

Ein maximaler Effekt wird in dem dargestellten Fall erreicht, wenn der Strahldurchmesser etwa 0,1 mm ($\triangleq$ etwa 35 % des Lochdurchmessers) beträgt. Ein sehr starker Abfall der Strömungswirkung innerhalb des Loches ist beim Übergang des Strahldurchmessers von 0,16 mm ($\triangleq$ 53 % des Lochdurchmessers) auf einen Wert von 0,2 mm ($\triangleq$ 67 % des Lochdurchmessers) zu beobachten. Bereits kleinere Änderungen des Durchmessers zu größeren Werten hin ergeben drastische Wirkungen. Dasselbe gilt auch bei einer Änderung des Strahldurchmessers von 0,05 mm ($\triangleq$ 17 %) zu 0,025 mm ($\triangleq$ 8,3 %).

Die erfindungsgemäße Wirkung wird dann nicht beobachtet, wenn nicht zusammenhängende, sondern bereits in einzelne Tröpfchen zerfallene Strahlen den Locheingang passieren.

Die feinen Flüssigkeitsstrahlen können durch Ausströmen des Behandlungsmittels aus geeigneten Düsen erzeugt werden. Hierzu werden ausreichend feine Löcher als Düsenaustrittsöffnungen in eine Düsenkammer oder allgemein als Düse bezeichnete Strahlerzeugungseinrichtung eingebracht, in die das flüssige Behandlungsmittel einströmt. Zur Erzeugung der Strahlen wird die Flüssigkeit unter Druck gesetzt. Die Stabilität der Flüssigkeitsstrahlen gegen eine Tröpfchenbildung hängt von verschiedenen Faktoren ab:

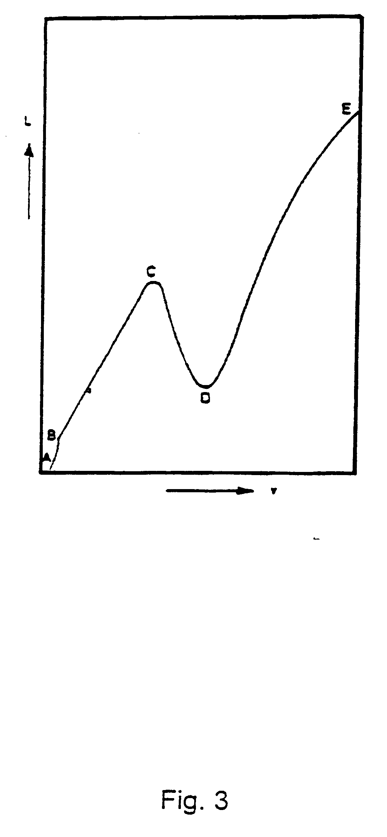

Die Erfindung bedient sich dabei einer für sich bekannten Technik zur Bildung laminarer Strahlen jenseits der Düsenöffnung (M.J. McCarthy, N.A. Molloy, "Review of Stability of Liquid Jets and the Influence of Nozzle Design", The Chemical Engineering Journal, Band 7 (1974) Seiten 1 bis 20). Die Strahlen neigen bei gasförmiger Umgebung grundsätzlich dazu, nach einer bestimmten Lauflänge (Zerfallslänge L), d.h. in einer bestimmten Entfernung von der Düsenaustrittsöffnung, in Tropfen zu zerfallen. Diese Tendenz wird vor allem durch die Oberflächenspannung der aus den Düsenöffnungen austretenden Flüssigkeit gegenüber dem Medium, das die Freistrahlen umgibt, beeinflußt. In Abhängigkeit von der dimensionslosen Weberzahl We der Flüssigkeitsstrahlen werden verschieden große Zerfallslängen beobachtet. Eine charakteristische Abhängigkeit der Zerfallslänge L von der Austrittsgeschwindigkeit v der Flüssigkeit aus der Düsenöffnung ist in Fig. 3 dargestellt. Danach ergibt sich eine komplizierte Abhängigkeit der Zerfallslänge L von der Austrittsgeschwindigkeit. Lediglich im unteren Geschwindigkeitsbereich hängt die Zerfallslänge ungefähr proportional von der Geschwindigkeit v ab.

Die Zerfallslänge kann also nicht unabhängig von der Reynoldszahl Re des Flüssigkeitsstrahles gewählt werden, wenn eine bestimmte Flüssigkeit verwendet wird. Für die erfindungsgemäße Anwendung der Freistrahlen muß die Zerfallslänge L möglichst groß sein, um die Ausbildung eines geschlossenen Flüssigkeitsstrahles zwischen der Düse und der zu behandelnden Werkstückoberfläche bzw. der darin enthaltenen Löcher und Vertiefungen sicherzustellen. Die für die Zerfallslänge L charakteristische dimensionslose Größe ist die Weberzahl We, die von der Dichte p des flüssigen Behandlungsmittels, der Oberflächenspannung σ des Behandlungsmittels, der Austrittsgeschwindigkeit v und dem Austrittsdurchmesser d des Behandlungsmittelstrahls in folgender Weise abhängt:

$$We = v^2 \cdot d \cdot \rho \cdot \sigma^{-1},$$

Tabelle 1:

| Versuch Nr. | Strahlgeschwindigkeit [m/s] | Strahldurchmesser [mm] | Bodengeschwindigkeit [m/s] |
|---|---|---|---|
| 1 | 3,0 | 0,1 | 0,45 |
| 2 | 1,5 | 0,2 | 0,01 |
| 3 | 1,5 | 0,16 | 0,1 |
| 4 | 1,5 | 0,14 | 0,12 |
| 5 | 1,5 | 0,1 | 0,22 |
| 6 | 1,5 | 0,05- | 0,1 |
| 7 | 1,5 | 0,025 | 0,01 |

Für rohrförmige Düsen ist die dimensionslose Zerfallslänge L/d im unteren Geschwindigkeitsbereich eine Funktion der Quadratwurzel aus der Weberzahl $\sqrt{We}$.

Eine Zerfallslänge von einigen Zentimetern kann beispielsweise erreicht werden, wenn ein Strahldurchmesser von 150 µm gebildet wird und wenn ein wäßriger Flüssigkeitsstrahl unter Druck aus einer entsprechenden Düsenöffnung in Gas, beispielsweise in Luft, gebildet wird. Die Weberzahl nimmt den Wert We = 206,9 an, so daß $\sqrt{We}$ = 14,4 ist, wenn ein wäßriges Behandlungsmittel mit einer Austrittsgeschwindigkeit von v = 10 m/s und einem Austrittsdurchmesser von d = 150.10$^{-6}$ m in Luft gestrahlt wird ($\sigma$ = 72,5·10$^{-3}$ N/m, p = 1 g/cm$^3$). In diesem Fall erhält man eine dimensionslose Zerfallslänge von L/d = 86, d.h. die Zerfallslänge L beträgt 12,9 mm. Innerhalb dieser Strecke ist der Strahl homogen und zerfällt nicht in einzelne Tröpfchen. Ein zu behandelndes Substrat, das in einem Abstand von weniger als dieser Länge von der Düsenaustrittsöffnung angeordnet ist, wird von einem feinen Strahl mit einem Strahldurchmesser von etwa 150 µm getroffen, so daß die erfindungsgemäße Wirkung erzielt werden kann.

Wird die flüssige Behandlungslösung dagegen nicht in eine gasförmige Atmosphäre, sondern in eine Flüssigkeit eingespritzt, so ergeben sich andere Verhältnisse, da in diesem Fall die Reynoldszahl des Strahles die charakterisierende Größe darstellt. Wird als Flüssigkeit, durch die der Strahl des Behandlungsmittels hindurch in die Löcher des sich ebenfalls in dieser Flüssigkeit befindenden Werkstückes gespritzt wird, die Flüssigkeit verwendet, mit der das Werkstück behandelt werden soll, so zerfällt der Strahl nicht mehr in einzelne Tröpfchen, da die Oberflächenspannung $\sigma$ gegen Null geht. In diesem Fall weitet sich der Strahl durch die höhere Viskosität des die Düse umgebenden Mediums dagegen etwas auf.

Daher stellt eine Verfahrensvariante, bei der sich das zu behandelnde Werkstück in dem flüssigen Behandlungsmittel befindet und bei der die Düsenaustrittsöffnungen, die der Werkstückoberfläche dicht gegenüberliegen, ebenfalls in das Behandlungsmittel eintauchen, eine bevorzugte Ausführungsform dar, da hiermit sehr feine, stabile Strahlen erzeugt werden können.

Für die Behandlung von Leiterplatten, in denen sich über die gesamte Oberfläche verteilt Durchgangs- und Sacklöcher befinden, ist es ferner vorteilhaft, die Leiterplatte und die Düse kontinuierlich relativ zueinander zu bewegen. Beispielsweise könnte die Leiterplatte in horizontaler Lage und horizontaler Richtung vorzugsweise in geringem Abstand an einer stationären Düse vorbeibewegt werden. Andererseits ist es auch möglich, die Düse an der Leiterplatte vorbeizubewegen, beispielsweise wenn die Leiterplatte an einem Gestell in vertikaler Anordnung befestigt ist und mit diesem zusammen in ein Behandlungsbad eingetaucht wird. Hierbei wird die Behandlungsflüssigkeit zur verbesserten Durchströmung aus den Düsenaustrittsöffnungen, die innerhalb der Behandlungsflüssigkeit angeordnet sind, auf die Leiterplattenoberfläche und in die Löcher gelenkt. In beiden Fällen überstreicht der Strahl des Behandlungsmittels die Oberfläche der Leiterplatte und wird dadurch nacheinander in die einzelnen Löcher in der Leiterplatte gelenkt.

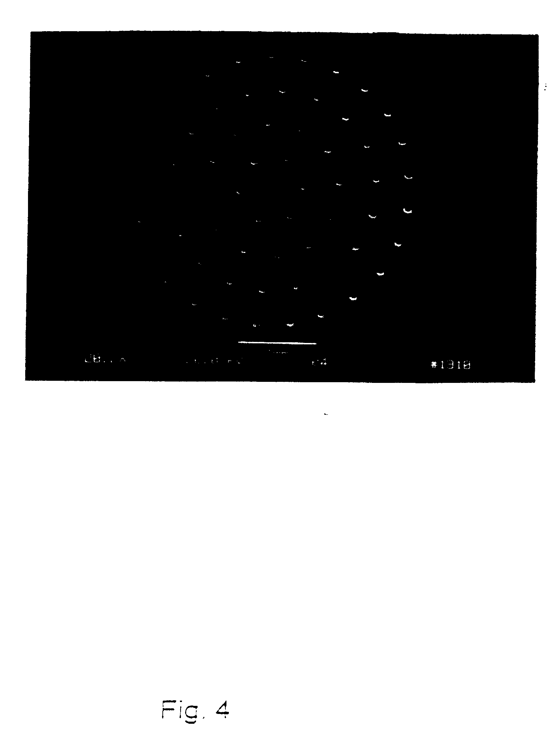

Für beide Anwendungsfälle mit linearer Relativbewegungsrichtung ist es auch vorteilhaft, mehrere Düsenaustrittsöffnungen z. B. im Lochabstand nebeneinander in einer geeigneten Vorrichtung vorzusehen. In Fig. 4 ist ein anderes Beispiel für eine kreisförmige Anordnung einer Vielzahl von feinsten Öffnungen von etwa 60 µm Durchmesser in einer Düsenmündungsfläche dargestellt. In einer anderen Ausführungsform können auch mehrere Reihen mit gegeneinander versetzt angeordneten Düsenaustrittsöffnungen, beispielsweise in einer im wesentlichen ebenen Düsenmündungsfläche, vorgesehen sein. Dadurch können mehrere Strahlen des Behandlungsmittels gleichzeitig und parallel zueinander auf die Leiterplattenoberfläche und in die Löcher gerichtet werden. Der Abstand der einzelnen Löcher darf jedoch einen kritischen Mindestabstand nicht unterschreiten, da die Flüssigkeitsstrahlen dazu neigen, miteinander zu verschmelzen.

Um die Flüssigkeitsstrahlen auch in Durchgangslöcher und Sacklöcher in Leiterplatten gezielt und gleichmäßig zu lenken, können die Düsenaustrittsöffnungen in der Düsenmündungsfläche so in mehreren Reihen gegeneinander versetzt angeordnet sein, daß der Versatz zwischen benachbarten Reihen oder ein Vielfaches dieses Versatzes etwa dem Abstand der Durchgangslöcher und/oder Sacklöcher entspricht.

Mit derartigen Anordnungen mit mehreren Düsenaustrittsöffnungen in der erfindungsgemäßen Vorrichtung wird erreicht, daß die einzelnen Löcher in der Leiterplatte beim Vorbeibewegen an der Düse von den Freistrahlen mit den Flüssigkeitsstrahlen behandelt werden.

Falls das Raster der in einer Matrix angeordneten Düsenöffnungen nicht mit dem Raster der auf der Leiterplatte angeordneten Löcher übereinstimmt, werden einzelne Löcher beim Vorbeibewegen der Leiterplatten an den Düsen trotzdem nicht von den Freistrahlen getroffen. In diesem Fall können die Düsen zusätzlich parallel zur Leiterplattenoberfläche und quer zur Relativbewegung der Leiterplatte zu den Düsen hin und her bewegt werden. Anstelle einer Hin- und Herbewegung können die Düsen auch in einer kreisförmigen oder elliptischen Bahn parallel zur Oberfläche der Leiterplatte bewegt werden.

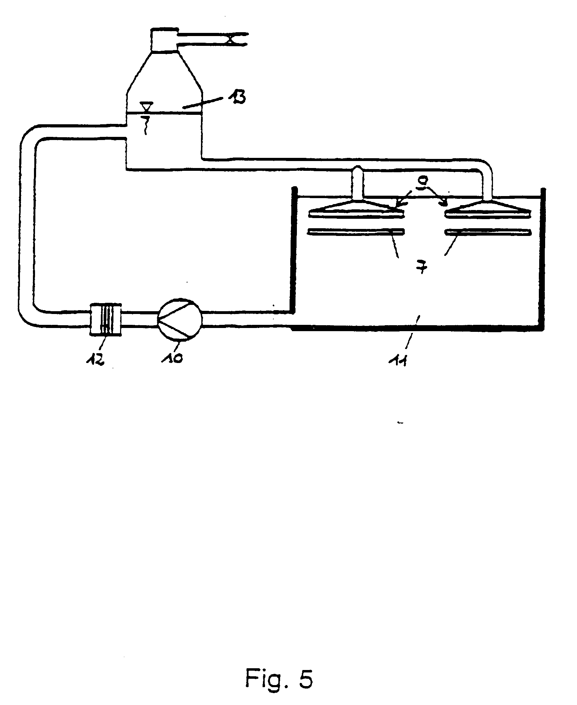

Zur Durchführung des Verfahrens wird eine Vorrichtung mit einer oder mehreren Düsen eingesetzt. Die in Fig. 5 schematisch dargestellte Vorrichtung umfaßt zwei Düsen 9 mit jeweils einer oder mehreren Düsenaustrittsöffnungen mit einem Durchmesser unter 0,5 mm, ferner eine Flüssigkeitsversorgungseinheit, typischerweise eine Pumpe 10, mittels derer flüssiges Behandlungsmittel 11 durch die Düsenaustrittsöffnungen gepumpt wird, und eine mit den Öffnungen und der Versorgungseinheit in Verbindung stehende Filtereinheit 12 zur Entfernung von Partikeln aus dem Behandlungsmittel. In unmittelbarer Nähe zu den Düsenaustrittsöffnungen werden die zu behandelnden Werkstücke, hier Leiterplatten 7, entweder stationär befestigt, oder die Werkstücke werden mittels geeigneter Transportmittel in unmittelbarer Nähe zu den Düsenaustrittsöffnungen an den Düsen vorbeibewegt.

Um zu verhindern, daß die sehr kleinen Austrittsöffnungen durch Partikel in der Behandlungsflüssigkeit verstopft werden, muß die Flüssigkeit vor dem Austreten aus der Düse sehr sorgfältig auch von sehr feinen Partikeln oder Verunreinigungen befreit werden. Hierzu ist die Filtereinheit 12 vorgesehen. Ferner wird die Flüssigkeit mittels einer Blasenfalle 13 vor dem Eintritt in die Düsen von mitgerissenem Gas befreit, um zu verhindern, daß die Strahlen durch aus den Öffnungen austretende Luft gestört werden.

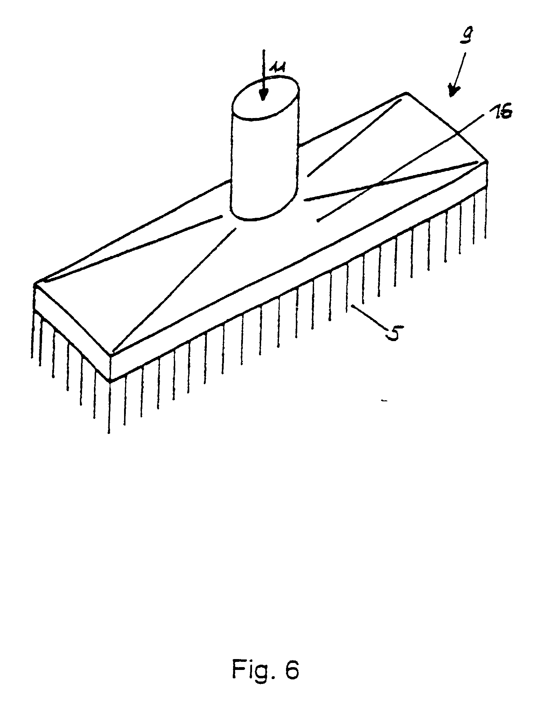

Zur Erzeugung ausreichend stabiler und feiner Freistrahlen sind Düsen mit sehr feinen Düsenaustrittsöffnungen, beispielsweise mit einem Durchmesser von 0,02 mm bis 0,5 mm, vorzusehen. Die Durchmesser und der Rasterabstand der einzelnen Düsenlöcher können dem Durchmesser und dem Rasterabstand der Löcher in den Leiterplatten angepaßt werden. Hierzu können beispielsweise geeignete Hohlkörper mit Öffnungen an einer vorzugsweise ebenen Seite (Düsenmündungsfläche) verwendet werden (Fig. 6). Die Düsenöffnungen werden beispielsweise durch Laserbohren hergestellt. Die Löcher können auch mittels eines chemischen Ätzprozesses erzeugt werden, indem auf die Oberfläche, in die die Löcher geätzt werden sollen, ein gegen das Ätzmittel beständiger Photoresist aufgebracht wird, dieser mit dem Lochmuster belichtet wird und die Löcher nach dem Entwickeln durch ein geeignetes Ätzmittel gebildet werden.

Der Flüssigkeitsstrahl 5 wird durch die in der Unterseite der Düse befindlichen Düsenaustrittsöffnungen erzeugt. Hierzu wird die Flüssigkeit 11 von oben her unter Druck in die Düse eingeleitet.

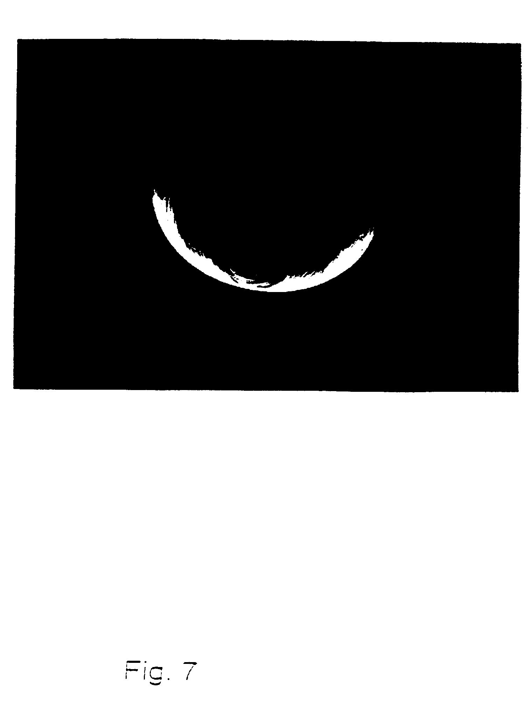

Die Form der Austrittsöffnungen ist ebenfalls kritisch für die Qualität der gebildeten Freistrahlen. Insbesondere sich in der Richtung des Strahles 5 des Behandlungsmittels verjüngende Öffnungen (Fig. 7) gewährleisten, daß die Geschwindigkeitsverteilung der Flüssigkeit in den Strahlen keine radialen Inhomogenitäten aufweist, so daß die Strahlen nur in geringem Maße zum Aufweiten oder zum Zerfallen in einzelne Tröpfchen neigen.

Werden Düsen mit matrixartig in mehreren Reihen angeordneten Düsenaustrittsöffnungen verwendet, so muß ferner dafür gesorgt werden, daß alle Flüssigkeitsstrahlen mit annähernd demselben Druck aus den Öffnungen austreten. Andernfalls können keine gleichmäßigen Ergebnisse erzielt werden. Hierzu ist die Verteilkammer 16 in der Düse vorgesehen, durch die die Behandlungsflüssigkeit vor dem Durchtritt durch die Austrittsöffnungen hindurchfließt, so daß die Durchflußmengen des durch die einzelnen Öffnungen austretenden Behandlungsmittels vergleichmäßigt werden. Die konstruktive Auslegung derartiger Verteilkammern ist nach Gesichtspunkten möglich, die in: F. Durst, U. Lange und H. Raszillier, "Optimization of Distribution Chambers of Coating Facilities", Chemical Engineering Science, Band 49 (1994), Heft 2, Seiten 161 bis 170 ausführlich beschrieben sind.

Leiterplatten können vorzugsweise in horizontaler Lage und in horizontaler Richtung durch eine Behandlungsanlage geschleust werden, in der die Behandlungsflüssigkeit von oben und/oder von unten an die Leiterplattenoberflächen gelenkt wird. Die Leiterplatten werden in diesem Fall in geringem Abstand an den Düsen vorbeigeführt. Innerhalb der Behandlungskammer befinden sich die Leiterplatten ebenso wie die Düsenöffnungen bevorzugt innerhalb der Behandlungslösung.

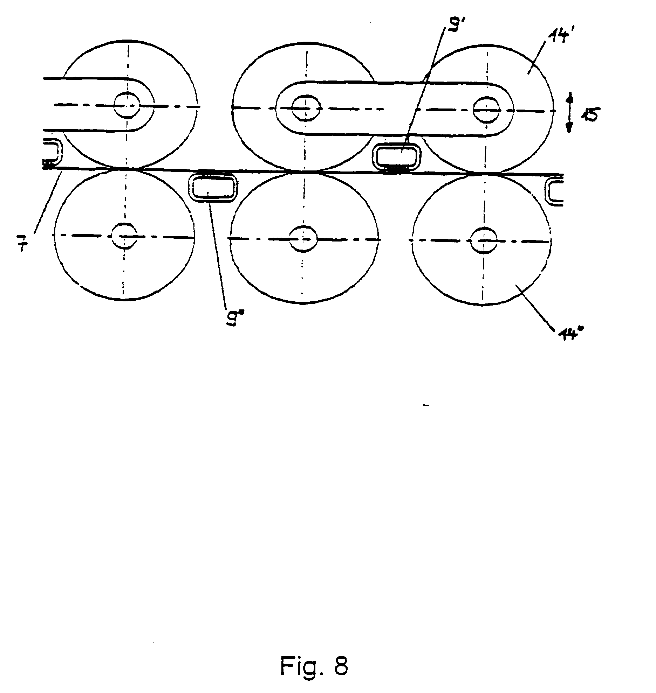

Um die Leiterplatten durch die Anordnung hindurchzubewegen, sind Transporteinrichtungen (Walzen oder Räder) 14', 14" vorgesehen, zwischen denen die Leiterplatten 7 hindurchgeführt werden (Fig. 8). Die Transporteinrichtungen erstrecken sich ebenso wie die Düsen vorzugsweise über die gesamte Breite der Leiterplatten. Zwischen den Transporteinrichtungen sind die erfindungsgemäßen Düsen 9', 9" angeordnet. Die oberen Transporteinrichtungen 14' sind mit den Düsen 9' in einer festen Einheit verbunden. Während die unteren Transporteinrichtungen 14" und die unteren Düsen 9" eine feste vertikale Position einnehmen, sind die oberen Transporteinrichtungen und Düsen in vertikaler Richtung 15 bewegbar, so daß Dickenunterschiede der Leiterplatten ausgeglichen werden können. Da die oberen Transporteinrichtungen und Düsen miteinander verbunden sind, kann ein fester Abstand zwischen den Düsenöffnungen und der Leiterplattenoberfläche eingestellt werden.

Anstelle von Leiterplatten können mit dem erfindungsgemäßen Verfahren auch andere Festkörper bzw. Werkstükke mit feinen Öffnungen und Vertiefungen wirksam behandelt werden. Beispielsweise können feine Siebe, Spinndüsen oder ähnliche Werkstücke vorteilhaft gereinigt werden.

Nachfolgendes Beispiel dient zur näheren Erläuterung der Erfindung:

Sacklöcher mit einem Durchmesser von 0,3 mm in Leiterplattenzuschnitten ohne Kupferkaschierung aus FR4-Material (Epoxidharzplatten mit Glasfasermatten zur Verstärkung, FR: flame retardent) und mit unterschiedlichen Sacklochtiefen sollten mit einer wäßrigen Permanganatlösung behandelt werden.

Die Platten enthielten die Löcher in einzelnen Testfeldern mit gleichen Sacklochtiefen von 0,3 mm, 0,5 mm, 1,0 mm bzw. 2,0 mm innerhalb der Felder. Die Löcher waren innerhalb der 25 mm x 25 mm großen Testfeldmatrices im Abstand von jeweils 0,6 mm (Mittenabstand der Löcher) angeordnet.

Die Leiterplattenzuschnitte wurden in horizontaler Richtung durch eine Behandlungsanlage, in der die Platten in horizontaler Lage ausgerichtet waren, kontinuierlich hindurchtransportiert. Die Behandlungslösung wurde von unten her an die Leiterplattenzuschnitte herangeführt. Zum einen diente hierzu eine Feinstrahl-Düsenbürste mit Öffnungen von 0,1 mm Durchmesser und mit einem 30 mm breiten Düsenöffnungsbereich (Gesamtöffnungsquerschnitt etwa 120 mm$^2$), die im Abstand von 0,5 mm voneinander angeordnet waren. Ferner war in der Behandlungsanlage auch ein herkömmlicher Schwalldüsenstock unterhalb der Bewegungsebene für die Leiterplattenzuschnitte vorgesehen, durch den ein dicker Schwallstrahl der Behandlungslösung an die Leiterplattenoberfläche herangeführt wurde. Der Abstand der Schwalldüsen zur Leiterplattenoberfläche betrug 5 mm, der der Feinstrahldüsenbürste zur Platte 15 mm.

Die Zuschnitte wurden in mehreren Versuchen mit Vorschubgeschwindigkeiten von 0,2 m/min und 0,5 m/min durch die Anlage bewegt.

Zur Auswertung des Behandlungserfolges der einzelnen Löcher in dem transparenten Leiterplattenmaterial wurde der Wandflächenanteil innerhalb der Löcher, der durch die Permanganatbehandlung verfärbt war, mittels eines Stereomikroskopes in der Querschnittsansicht der Platte beurteilt. In den nachstehenden Tabellen sind die Ergebnisse der Versuche wiedergegeben. Die angegebenen Werte stellen den Anteil der verfärbten Fläche innerhalb der Löcher dar. Ein geringer Anteil verfärbter Wandfläche deutet auf einen unzureichenden Flüssigkeitstransport in die Löcher.

Tabelle 1

| (Feinstrahldüse): | | | |
|---|---|---|---|
| Durchlaufgeschwindigkeit [m/min] | Lochtiefe 0,3 mm | Lochtiefe 0,5 mm | Lochtiefe 1,0 mm |
| 0,2 | 100 % | 100 % | 100 % |
| 0,5 | 100 % | 100 % | 100 % |

Tabelle 2

| (Schwalldüse): | | | |
|---|---|---|---|
| Durchlaufgeschwindigkeit [m/min] | Lochtiefe 0,3 mm | Lochtiefe 0,5 mm | Lochtiefe 1,0 mm |
| 0,2 | 100% | 100% | 35% |
| 0,5 | 100 % | 100 % | 10% |

**Patentansprüche**

1. Verfahren zum Behandeln von sich in Werkstücke erstreckenden Löchern oder Vertiefungen mit einer Öffnungsweite unter 0,5 mm mit einem aus einer Düse austretenden flüssigen Behandlungsmittel, dadurch gekennzeichnet, daß ein Strahl des Behandlungsmittels mit einem Durchmesser, der kleiner ist als die Öffnungsweite, vorzugsweise kleiner als die Hälfte der Öffnungsweite, in die Löcher oder Vertiefungen gerichtet wird.

2. Verfahren nach einem der vorstehenden Ansprüche, dadurch gekennzeichnet, daß der Strahl des flüssigen Behandlungsmittels durch eine Flüssigkeit hindurch auf die in dieser Flüssigkeit oder durch einen Gasraum hindurch auf die in diesem Gasraum befindlichen Werkstücke gerichtet wird.

3. Verfahren nach einem der vorstehenden Ansprüche, dadurch gekennzeichnet, daß das Werkstück und der Strahl relativ zueinander bewegt werden, so daß der Strahl des Behandlungsmittels die Oberfläche des Werkstücks überstreicht und nacheinander in die einzelnen Löcher oder Vertiefungen gerichtet wird.

4. Verfahren nach einem der vorstehenden Ansprüche, dadurch gekennzeichnet, daß mehrere Strahlen des Behandlungsmittels gleichzeitig und parallel zueinander auf die Oberfläche des Werkstücks und in die Löcher und/oder Vertiefungen gerichtet werden.

5. Verfahren nach einem der vorstehenden Ansprüche, dadurch gekennzeichnet, daß die Düse quer zur Relativbewegung und parallel zur Oberfläche des Werkstücks hin und her oder in einer kreisförmigen oder elliptischen Bahn parallel zur Oberfläche des Werkstücks bewegt wird.

6. Verfahren nach einem der vorstehenden Ansprüche, dadurch gekennzeichnet, daß Leiterplatten in horizontaler Lage und horizontaler Richtung in geringem Abstand an der Düse vorbeigeführt werden.

7. Anwendung des Verfahrens nach einem der vorstehenden Ansprüche zur Behandlung von mit Durchgangslöchern und/oder Sacklöchern versehenen Leiterplatten.

8. Vorrichtung zur Durchführung des Verfahrens nach einem der vorstehenden Ansprüche, gekennzeichnet durch eine Düse (9) mit einer oder mehreren Düsenaustrittsöffnungen mit einem Durchmesser unter 0,5 mm, einer Flüssigkeitsversorgungseinheit (10), mittels derer flüssiges Behandlungsmittel durch die Düsenaustrittsöffnungen gepumpt wird, und einer mit den Öffnungen und der Versorgungseinheit in Verbindung stehenden Filtereinheit (12) zur Entfernung von Partikeln aus dem Behandlungsmittel (11).

9. Vorrichtung nach Anspruch 8, dadurch gekennzeichnet, daß sich die Düsenaustrittsöffnungen in der Richtung des Behandlungsmittelstrahles (5) verjüngen.

10. Vorrichtung nach einem der Ansprüche 8 oder 9, gekennzeichnet durch mehrere Düsenaustrittsöffnungen in einer Matrixanordnung in einer im wesentlichen ebenen Düsenmündungsfläche.

11. Vorrichtung nach Anspruch 10, dadurch gekennzeichnet, daß die Düsenaustrittsöffnungen in der Düsenmündungsfläche in mehreren Reihen gegeneinander versetzt angeordnet sind.

12. Vorrichtung nach einem der Ansprüche 8 bis 11, gekennzeichnet durch eine die Menge des durch die einzelnen Düsenöffnungen hindurchtretenden Behandlungsmittels (11) vergleichmäßigende und den Düsenaustrittsöffnungen vorgelagerte Verteilkammer (16) für das Behandlungsmittel.

13. Vorrichtung zum Behandeln von Durchgangslöchern und Sacklöchern in Leiterplatten nach einem der Ansprüche 8 bis 12, dadurch gekennzeichnet, daß die Düsenaustrittsöffnungen in einer im wesentlichen ebenen Düsenmündungsfläche in mehreren Reihen gegeneinander versetzt angeordnet sind und daß der Versatz zwischen benachbarten Reihen oder ein Vielfaches dieses Versatzes etwa dem Abstand der Durchgangslöcher und/oder Sacklöcher voneinander entspricht.

14. Vorrichtung nach einem der Ansprüche 12 bis 13, gekennzeichnet durch Mittel zum horizontalen Bewegen der in horizontaler Lage angeordneten Leiterplatten (7) relativ zur Düse (9).

15. Vorrichtung nach Anspruch 14, dadurch gekennzeichnet, daß mehrere Düsen (9',9") zwischen Transporteinrichtungen (14',14"), mittels derer die Leiterplatten (7) bewegt werden, angeordnet sind und daß sich die Düsen (9', 9") mindestens über die gesamte Breite der Leiterplatten (7) erstrecken.

## Claims

1. Method of treating holes or cavities, having a width of opening below 0.5 mm and extending in workpieces, with a liquid treatment agent emerging from a nozzle, characterised in that a jet of the treatment agent, having a diameter which is smaller than the width of opening, preferably smaller than half the width of opening, is directed into the holes or cavities.

2. Method according to one of the preceding claims, characterised in that the jet of the liquid treatment agent is directed through a liquid onto the workpieces situated in this liquid or through a gas chamber onto the workpieces situated in this gas chamber.

3. Method according to one of the preceding claims, characterised in that the workpiece and the jet are moved relative to each other, so that the jet of the treatment agent sweepsover the surface of the workpiece and is directed successively into the individual holes or cavities.

4. Method according to one of the preceding claims, characterised in that a plurality of jets of the treatment agent are directed simultaneously and parallel to one another onto the surface of the workpiece and into the holes and/ or cavities.

5. Method according to one of the preceding claims, characterised in that the nozzle is moved back and forth transversely to the relative movement and parallel to the surface of the workpiece, or is moved in a circular or elliptical path parallel to the surface of the workpiece.

6. Method according to one of the preceding claims, characterised in that printed circuit boards are guided past the nozzle in a horizontal position and in a horizontal direction at a small spacing therefrom.

7. Use of the method according to one of the preceding claims for the treatment of printed circuit boards provided with through-holes and/or blind-holes.

8. Apparatus for accomplishing the method according to one of the preceding claims, characterised by a nozzle (9) provided with one or more nozzle outlet apertures having a diameter below 0.5 mm, a liquid supply unit (10) by means of which liquid treatment agent is pumped through the nozzle outlet apertures, and a filter unit (12) which communicates with the apertures and the supply unit for the removal of particles from the treatment agent (11).

9. Apparatus according to claim 8, characterised in that the nozzle outlet apertures taper in the direction of the treatment agent jet (5).

10. Apparatus according to one of claims 8 or 9, characterised by a plurality of nozzle outlet apertures in a matrix arrangement in a substantially flat nozzle mouth area.

11. Apparatus according to claim 10, characterised in that the nozzle outlet apertures in the nozzle mouth area are disposed so as to be offset from one another in a plurality of rows.

12. Apparatus according to one of claims 8 to 11, characterised by a distribution chamber (16) for the treatment agent, which chamber regulates the quantity of treatment agent (11) passing through the individual nozzle apertures and is mounted upstream of the nozzle outlet apertures.

13. Apparatus for treating through-holes and blind-holes in printed circuit boards according to one of claims 8 to 12, characterised in that the nozzle outlet apertures in a substantially flat nozzle mouth area are disposed so as to be offset from one another in a plurality of rows; and in that the offset arrangement between adjacent rows or a multiple of this offset arrangement corresponds substantially to the spacing between the through-holes and/or blind-holes.

14. Apparatus according to one of claims 12 to 13, characterised by means for horizontally moving the printed circuit boards (7), which are disposed in a horizontal position, relative to the nozzle (9).

15. Apparatus according to claim 14, characterised in that a plurality of nozzles (9', 9") are disposed between conveying arrangements (14', 14"), by means of which the printed circuit boards (7) are moved; and in that the nozzles (9', 9") extend over at least the entire width of the printed circuit boards (7).

**Revendications**

1. Procédé pour traiter des trous ou des évidements s'étendant dans des pièces ayant une largeur d'ouverture inférieure à 0,5 mm avec un agent liquide de traitement sortant d'une buse, caractérisé en ce qu'un jet de l'agent de traitement ayant un diamètre qui est inférieur à la largeur d'ouverture, de préférence inférieur à la moitié de la largeur d'ouverture, est dirigé dans les trous ou évidements.

2. Procédé selon l'une quelconque des revendications précédentes, caractérisé en ce que le jet de l'agent liquide de traitement est dirigé à travers un liquide sur les pièces se trouvant dans ce liquide ou à travers un espace gazeux sur les pièces se trouvant dans cet espace gazeux.

3. Procédé selon l'une quelconque des revendications précédentes, caractérisé en ce que la pièce et le jet sont déplacés l'un par rapport à l'autre, de sorte que le jet de l'agent de traitement balaie la surface de la pièce et est dirigé successivement dans les différents trous ou évidements.

4. Procédé selon l'une quelconques des revendications précédentes, caractérisé en ce que plusieurs jets de l'agent de traitement sont dirigés simultanément et parallèlement l'un à l'autre sur la surface de la pièce et dans les trous et/ou évidements.

5. Procédé selon l'une quelconques des revendications précédentes, caractérisé en ce que la buse est déplacée selon un mouvement de va-et-vient transversalement au mouvement relatif et parallèlement à la surface de la pièce ou dans une trajectoire circulaire ou elliptique parallèlement à la surface de la pièce.

6. Procédé selon l'une quelconque des revendications précédentes, caractérisé en ce que l'on fait passer les cartes imprimées dans la position horizontale et dans le sens horizontal à faible distance devant la buse.

7. Application du procédé selon l'une quelconque des revendications précédentes pour traiter des cartes imprimées pourvues de trous de passage et/ou de trous borgnes.

8. Dispositif pour appliquer le procédé selon l'une quelconque des revendications précédentes, caractérisé par une buse (9) pourvue d'un ou de plusieurs orifices de sortie de buse avec un diamètre inférieur à 0,5 mm, d'une unité d'alimentation en liquide (10), au moyen de laquelle un agent liquide de traitement est pompé par les orifices de sortie de buse, et d'une unité de filtrage (12) communiquant avec les orifices et l'unité d'alimentation pour éliminer les particules de l'agent de traitement (11).

9. Dispositif selon la revendication 8, caractérisé en ce que les orifices de sortie de buse se rétrécissent dans la direction du jet de l'agent de traitement (5).

10. Dispositif selon l'une quelconque des revendications 8 ou 9, caractérisé par plusieurs orifices de sortie de buse dans un arrangement matriciel dans une surface de dégorgement de buse qui est sensiblement plane.

11. Dispositif selon la revendication 10. caractérisé en ce que les orifices de sortie de buse sont disposés dans la surface de dégorgement de buse sur plusieurs rangées et décalés les uns par rapport aux autres.

12. Dispositif selon l'une quelconque des revendications 8 à 11, caractérisé par une chambre de distribution (16) pour l'agent de traitement, qui homogénéise la quantité de l'agent de traitement (11) traversant les différents orifices de buse et est placée en amont des orifices de sortie de buse.

13. Dispositif pour traiter des trous de passage et des trous borgnes dans des cartes imprimées selon l'une quelconque des revendications 8 à 12, caractérisé en ce que les orifices de sortie de buse sont disposés dans une surface de dégorgement de buse sensiblement plane sur plusieurs rangées et de façon décalée les uns par rapport aux autres et en ce que le déport entre des rangées voisines ou un multiple de ce déport correspond à peu près à l'espacement des trous de passage et/ou des trous borgnes.

14. Dispositif selon l'une quelconque des revendications 12 à 13, caractérisé par des moyens pour le déplacement horizontal, par rapport à la buse (9), des cartes imprimées (7) disposées en position horizontale.

15. Dispositif selon la revendication 14, caractérisé en ce que plusieurs buses (9',9") sont disposées entre des appareils de transport (14', 14"), au moyen desquels les cartes imprimées (7) sont déplacées, et en ce que les buses (9', 9") s'étendent au moins sur toute la largeur des cartes imprimées (7).

Fig. 1

Fig. 2

Fig. 3

Fig. 4

Fig. 5

Fig. 6

Fig. 7

Fig. 8